# EUROPEAN PATENT SPECIFICATION

(11) **EP 1 128 444 B1**
(45) Date of publication and mention of the grant of the patent: **28.09.2011**
(21) Application number: 01104045.8
(22) Date of filing: 20.02.2001
(51) Int. Cl.: H01L 31/048, H01L 31/072

(54) **Solar cell module**
Solarzellenmodul
Module de cellules solaires

(30) Priority: 21.02.2000 JP 2000042638
(43) Date of publication of application: 29.08.2001
(73) Proprietor: SANYO ELECTRIC CO., LTD., Moriguchi-shi, Osaka (JP)
(72) Inventor: Tsuge, Sadaji, Moriguchi-shi, Osaka (JP)
(74) Representative: Glawe, Delfs, Moll

(56) References cited:
- US-A- 5 733 382
- US-A- 5 994 641
- PATENT ABSTRACTS OF JAPAN vol. 006, no. 060 (E-102), 17 April 1982 (1982-04-17) & JP 57 001263 A (FUJI ELECTRIC CO LTD), 6 January 1982 (1982-01-06)
- JAGANNATHAN B ET AL: "PHOTOGENERATION AND CARRIER TRANSPORT IN AMORPHOUS SILICON/CRYSTALLINE SILICON DEVICES" AMORPHOUS AND MICROCRYSTALLINE SILICON TECHNOLOGY - 1997. SAN FRANCISCO, CA, MARCH 31 - APRIL 4, 1997, MATERIALS RESEARCH SOCIETY SYMPOSIUM PROCEEDINGS. VOL. 467, PITTSBURGH, PA: MRS, US, vol. 467, 31 March 1997 (1997-03-31), pages 801-806, XP000905785 ISBN: 1-55899-371-1

## Description

### BACKGROUND OF THE INVENTION

### Field of the Invention

This invention relates to a solar cell module, particularly relates to a two-side incidence type solar cell module provided with transparent front and rear surface members capable of entering light from both front and rear surfaces.

### Description of Prior Art

Because solar light is unexhausted energy, a solar cell device for directly converting light energy into electrical energy has been developed as energy source for substituting with environmentally harmful fossil fuel such as petroleum and coal. A plurality of solar cell elements are electrically connected in series or in parallel with each other to form a solar cell module and increase an output. The solar cell module can be used as a practical energy source.

A conventional solar cell module which generates power on one side surface is so structured that a plurality of solar cell elements 110 between a front surface glass 100 and a rear surface member 101 are sealed with transparent and insulative resin 102 such as EVA (ethylene vinyl acetate).

The solar cell element 110 contains semiconductor material such as single crystalline silicon, polycrystalline silicon, or the like, and the solar cell elements 110 are connected in series by connection member 111 of a metal thin plate such as a copper foil plate or the like. The rear surface member 101 is a lamination film with a metal foil such as an aluminum (Al) foil or the like sandwiched with plastic films so that water entrance from a rear surface can be prevented.

The above solar cell module is integrally formed by sandwiching the solar cell element 110 between the front surface glass 100 and the rear surface member 101 with a resin sheet of EVA or the like of 0.4-0.8mm in thickness interposed and heating it at a reduced pressure.

The solar cell element 110 is so structured that n-type impurities are diffused on a p-type single crystalline silicon substrate 110a to form an n-type semiconductor layer 110b so that semiconductor junction is formed. The rear surface electrode 110d of aluminum (Al) is formed on a rear surface side of the substrate 110a. The aluminum of the rear surface electrode 110d is diffused and a p+-type diffusion layer 110c is formed on the rear surface side of the substrate 110a. A comb-shaped electrode 110e of silver (Ag) is formed on a front surface side of the substrate and a silicon dioxide (SiO₂) layer as a reflection preventing layer 110f is formed.

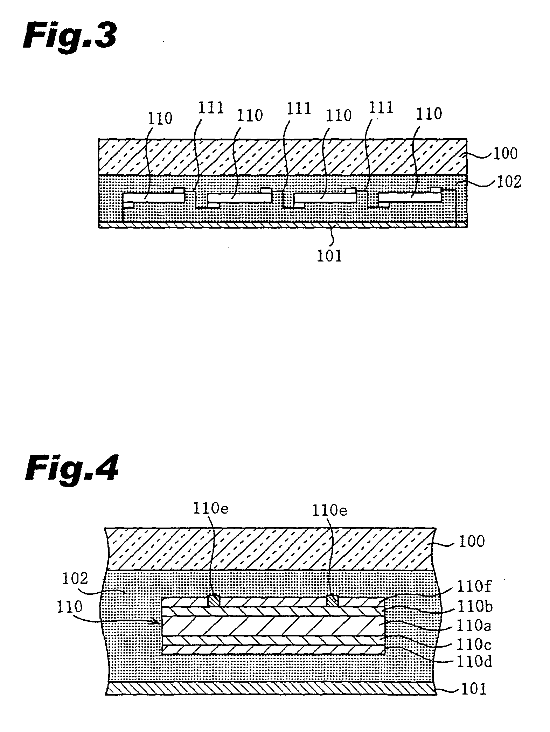

A conventional solar cell module has a structure with semiconductor junction arranged on a light incidence side of a front surface glass on as shown in Fig. 4 so that many carriers are generated on the light incidence side and a strong electric field on the junction separates the carriers.

A solar cell element capable of entering light from both front and rear surfaces with a structure that the electrode provided on the rear surface side not only on the front surface side is formed of transparent material has been proposed in order to efficiently utilize light.

In the meantime, a solar cell module should be weather proof in order to withstand long-term use in outside. When a lamination film as the rear surface member 101 which the metal foil is sandwiched with plastic films, water entrance from outside is suppressed and high power generation performance can be obtained for a long period of time.

The above solar cell element of the two-side incidence type uses for the rear surface member formed of transparent material. However, when a transparent resin film is used as the rear surface member, water is likely to enter as compared with a lamination film with a metal foil sandwiched with plastic films.

Although a film of a small water vapor transmission rate has been proposed as a transparent resin film, improvement is still required. US-A-5733382 discloses a solar cell module comprising a solar cell sandwiched between two glass substrates and a resin. The solar cells have shallow pn-junctions.

### Summary of the invention

This invention was made to solve the existing problems and to provide a solar cell module capable of improving reliability by improving moisture proofness.

This object is solved by the features of the main claim.

Advantageous embodiments are shown in the subclaims.

### BRIEF DESCRIPTION OF THE DRAWINGS

Fig. 1 is a schematic cross sectional view illustrating a solar cell module of an embodiment according to this invention;
Fig. 2 is a schematic cross sectional view illustrating a solar cell module of another embodiment according to this invention;
Fig. 3 is a schematic cross sectional view illustrating a conventional solar cell module;
Fig. 4 is a schematic cross sectional view illustrating the conventional solar cell module.

The foregoing and other objects, features, aspects and advantages of the present invention will become more apparent from the following detailed description of the present invention when reviewed in conjunction with the accompanying drawings.

### PREFERRED EMBODIMENT(S) OF THE INVENTION

First of all, the invention was made under the following condition. A solar cell module shown in Fig. 4 including a lamination film of an aluminum foil sandwiched with polyvinyl fluoride films, and a solar cell module only including a PVF film are prepared, and a moisture proof test (JIS C8917) on the two modules is conducted to examine a cause of degradation of power generation performance by water entrance. In this test, the modules are put in a thermostatic bath of 85°C, 93% RH for approximately 1000 hours and the solar cell characteristics are examined. An acceptable value of output is higher than 95%. In this test, the modules are put in the thermostatic bath for 1000 hours. The output change rate is 99.0 % when the rear surface member is a lamination film, and the rate is 92.0 % when the PVF film of 50µm is used.

A quantity of sodium in 1g of the resin for sealing the solar cells of the solar cell module using the lamination film is 0.3µg/g, and that of the solar cell module using only the PVF film is 3µg/g. The quantity of sodium relates to the change rate of output, and as the quantity of sodium in the resin increases, the power generation performance degrades.

An increase of sodium quantity seems to result from the water entered in the module. The water enters from an outer periphery of the solar cell module when the rear surface member is the lamination film. On the other hand, when the rear surface member is the resin film, water enters not only from the outer periphery of the solar cell module but also from the resin film. As a result, when the rear surface member is the resin film, the water entering in the module increases.

When the water enters in the solar cell module, the sodium ion deposited from the front glass surface migrates inside the resin containing the water and reaches to the surface of the solar cell element. Then, trap level is formed in the solar cell module and causes carrier loss. As a result, the power generation performance of the solar cell element degrades. Therefore, it is assumed that the resin film on the rear surface causes degradation of power generation performance.

The cause of this phenomenon is not clearly understood so far, but is supposed that the sodium (Na) does not directly join with silicon (Si), and affects through oxygen. Therefore, it is expected that the sodium acts when joining with an impurity diffusion layer (a dope layer) having a natural oxide layer or slightly remaining oxygen on the surface. When level is formed on a dope layer, a build-in electric field is weakened by reduction of carriers, and at an interface, re-joining increases and characteristics may be degraded.

This invention was made to improve reliability by not having alkaline composition such as the sodium deposited from the front surface glass affect to semiconductor junction of a solar cell element.

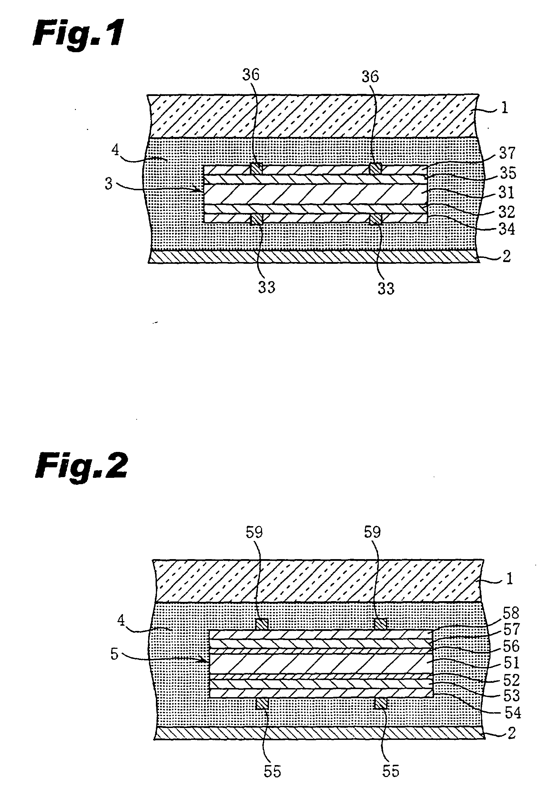

Explanation is made on the embodiment of this invention by referring to the drawings. Fig. 1 is a schematic cross sectional view of a solar cell module of the first embodiment of this invention.

The solar cell module according to the embodiment of this invention generates power at both front and rear surfaces, and has a structure that, as shown in Fig. 1, a plurality of solar cell elements 3 is sealed with transparent and insulative resin 4 such as EVA (ethylene vinyl acetate) between a front surface glass 1 and a rear surface member 2. The rear surface member 2 is a transparent plastic film of PVF or the like so that light can be entered from the rear surface. In Fig. 1, a single unit of the solar cell element 3 is shown. The solar cell elements are connected with each other in series or in parallel by connection lead such as a copper foil.

The transparent plastic film may be heat-resistant film of PET (polyethylene telephtharate), PVDF (polyvinylidene fluoride), FEP (tetrafluoroethylene hexafluoro propylene copolymer), ETFE (ethylene tetrafluoroethylene copolymer), PC (polycarbonate), PVC (polyvinyl chloride), or PMMA (acrylic), other than PVF (polyvinyl fluoride).

The solar cell element 3 used in the solar cell module of this invention has semiconductor junction which n-type impurity is diffused on a p-type single crystalline silicon substrate 31 and an n-type semiconductor layer 32 is formed. A comb-shaped electrode 33 of Ag is provided on the n-type semiconductor layer 32 and a reflection preventing layer 34 of a silicon dioxide (SiO₂) layer is formed thereon.

The solar cell element 3 is arranged in the solar cell module so that semiconductor junction of the solar cell element 3 is positioned on an opposite side of the front surface glass substrate 1. Therefore, it is required that the solar cell element 3 can enter light from an opposite surface to the surface for forming junction in the conventional solar cell element. Thus, after forming a p+-type diffusion layer 35 positioned on a side of the glass substrate 1 by aluminum diffusion, the A1 is eliminated or a p+-type amorphous semiconductor layer is formed on the substrate 31 in order to achieve light entrance.

The comb-shaped electrode 36 of Ag is formed on the p-type semiconductor layer 35, and a reflection preventing layer 37 of a silicon dioxide (SiO₂) layer is formed.

The solar cell elements are sandwiched with an EVA resin sheet so as to locate semiconductor junction of the solar cell element 3 between the front surface glass 1 and the rear surface member 2 on an opposite side of the front surface glass 1 and is heated under a reduced pressure so that the module is integrally formed.

In forming the solar cell module shown in Fig. 1, each of the layers is superimposed on the front surface glass 1 and is held in a vacuumed bath of approximately 100Pa. Then, it is heated to be approximately 150°C and is pressed with a silicon sheet from a side of the rear surface member 2 by an atmospheric pressure. In this process the EVA resin is softened and is tentatively adhered. Then, it is held in a thermostatic bath of approximately 150°C for about one hour, and the EVA resin is cross-linked.

As shown in Fig. 1, the plurality of the solar cell elements are sealed with the EVA resin between the front surface glass 1 and the rear surface member 2, where the semiconductor junction is positioned on an opposite side of the front surface glass 1.

As described above when the semiconductor junction is apart from the front surface glass 1, the alkaline component such as the sodium ions are shielded by a thick bulk semiconductor, and effects to a junction part which is important in forming an electric filed can be substantially eliminated. Therefore, degradation of power generation performance of the solar cell element 3 can be prevented. As a result, a highly reliable solar cell module capable of withstanding long-term use in outside can be provided.

The solar cell module of the structure according to this invention and a conventional solar cell module are prepared, and moisture proof test is conducted. This test is for examining characteristics of the solar cells before and after retained in a thermostatic bath of 85°C, 93% RH for 1000 hours. An acceptable value of an output is not lower than 95%. The results are shown in table 1.

The sample of the invention includes a transparent plastic film of PVF (polyvinyl fluoride) so as to enter light from the rear surface. The conventional example includes a lamination film of a metal (Al) foil as the rear surface member sandwiched with plastic films of PVF. The conventional example and the sample of the invention has the same structure except that the material of the rear surface member is different, and the semiconductor junction is positioned on a side of the glass substrate or on an opposite side of the glass substrate.

**Table 1**

| Table 1 | | | | (%) |
|---|---|---|---|---|
| | Pmax | Voc | Isc | F.F. |
| Module of this invention ( p-type substrate) | 99.1 | 99.9 | 100.0 | 99.2 |
| Module of the conventional example(p-type substrate ) | 95.8 | 99.4 | 100.0 | 96.3 |

Each of the values in the table is a rate of change from initial characteristics. As indicated in the table, degradation of the characteristics is suppressed in spite of the rear surface member of a plastic film which is subject to water entrance in the module with semiconductor junction positioned on the opposite side of the front surface glass 1

Explanation on the second embodiment of the invention is made by referring to Fig. 2. As shown in Fig. 2, this embodiment uses the solar cell element 5 capable of entering light from both front and rear surfaces and having a structure (an HIT structure) which a substantially intrinsic amorphous silicon is sandwiched between the single crystalline silicon substrate and the amorphous silicon layer so that defective on the interface is reduced and characteristics of the hetero junction interface is improved.

As shown in Fig. 2, the solar cell element 1 includes an n-type single crystalline silicon substrate 51, an intrinsic amorphous silicon layer 52, and a p-type amorphous silicon layer 53 formed in this order. A transparent electrode 54 on a light receiving side formed of ITO or the like is formed on an entire surface of the p-type amorphous silicon layer 53, and a comb-shaped collector 55 of silver (Ag) or the like is formed on the transparent electrode 54 on a light receiving side. An opposite surface of the substrate 51 has a BSF (Back Surface Field) structure which introduces an internal electric field on the rear surface of the substrate; a high dope n-type amorphous silicon layer 57 is formed with an intrinsic amorphous silicon layer 56 interposed on an opposite surface side of the substrate 51. A transparent electrode 58 on a rear surface side of ITO or the like is formed on an entire surface of the high dope n-type amorphous silicon layer 57, and a comb-shaped collector 59 of silver (Ag) or the like is formed thereon. The rear surface also has a BSF structure which the intrinsic amorphous silicon layer is sandwiched between the crystalline silicon substrate and the high dope amorphous silicon layer in order to reduce defective on the interface and improve characteristic of the hetero junction interface.

A plurality of the solar cell elements 5 are connected in series with connection member (not shown). The solar cell elements are arranged so as to position semiconductor junction on an opposite side of the front surface glass 1; that is a comb-shaped collector 59 on a side corresponding a side on the rear surface is positioned on the side of the glass substrate 1, and a p-type amorphous silicon layer 53 for forming semiconductor junction on the side of the rear surface film 2 is positioned.

The solar cell element 5 with the semiconductor junction positioned on the opposite side of the glass substrate 1 is sealed between the front surface glass 1 and the transparent rear surface film 2 of PVF or the like by using EVA (ethylene vinyl acetate) resin 4.

As described above when the semiconductor junction is apart from the front surface glass 1, the alkaline component such as the sodium ions are shielded by a thick bulk semiconductor, and effects to a junction part which is important in forming an electric filed can be substantially eliminated. Therefore, degradation of power generation performance of the solar cell element 3 can be prevented. As a result, a highly reliable solar cell module capable of withstanding long-term use in outside can be provided.

The solar cell module of the structure according to this invention and a conventional solar cell module are prepared, and moisture proof test is conducted. This test is for examining characteristics of the solar cells before and after retained in a thermostatic bath of 85°C, 93% RH for 1000 hours. An acceptable value of an output is not lower than 95%. The results are shown in table 2.

The sample of the invention includes a transparent plastic film of PVF (polyvinyl fluoride) so as to enter light from the rear surface. The conventional example includes a lamination film of a metal (Al) foil as the rear surface member sandwiched with plastic films of PVF. The conventional example and the sample of the invention has the same structure except that the material of the rear surface member is different, and the position of the semiconductor junction is positioned on a side of the glass substrate or on an opposite side of the glass substrate.

**Table 2**

| Table 2 | | | | (%) |
|---|---|---|---|---|
| | Pmax | Voc | Isc | F.F. |
| Module of the invention (HIT cell) | 99.5 | 100.0 | 99.9 | 99.6 |
| Module of conventional example (HIT cell) | 95.9 | 99.5 | 99.9 | 96.5 |

Each of the values in the table is a rate of change from initial characteristics. As indicated in the table, degradation of the characteristics is suppressed in spite of the rear surface member of a plastic film which is subject to water entrance in the module with semiconductor junction positioned on the opposite side of the front surface glass 1.

In the above description, a heat diffusion type single crystalline silicon solar cell element, and a solar cell element of an HIT structure are used. In addition, a crystalline solar cell element using other types of single crystalline silicon and polycrystalline silicon and an amorphous solar cell element are also applicable for a solar cell module.

This invention can provide a highly reliable solar cell module capable of withstanding long-term use in outside by suppressing sodium ions deposited from a front surface glass from reaching to a solar cell element, and retarding degradation of power generation performance of the solar cell element.

Although the present invention has been described and illustrated in detail, it should be clearly understood that the description discloses examples of different embodiments of the invention and is not intended to be limited to the examples or illustrations provided. Any changes or modifications within the scope of the present invention are intended to be included, the invention being limited only by the terms of the appended claims.

## Claims

1. A solar cell module comprising
a front surface side light transmitting member (1) of glass and containing at least sodium,
a rear surface member (2) made of a transparent plastic film, and
a solar cell element (3, 5) sealed with sealing resin between the front surface side light transmitting member (1) and the rear surface member (2), wherein the solar cell element has a semiconductor junction positioned on
the side of the solar cell facing away from the front surface side light transmitting member.

2. The solar cell module according to claim 1,
wherein the rear surface member is a transparent resin film.

3. The solar cell module according to claim 1,
wherein the solar cell element (3, 5) is a heat diffusing type single crystalline silicon solar cell element.

4. The solar cell module according to claim 1,
wherein the solar cell element (3, 5) includes an amorphous semiconductor layer in at least a part of the solar cell element.

5. The solar cell module according to claim 1,
wherein the solar cell element (5) includes a hetero junction (52) between a crystalline semiconductor (51) and an amorphous semiconductor (53).

## Patentansprüche

1. Solarzellenmodul mit
einem Vorderflächenseiten-Lichtübertragungselement (1) aus Glas, das zumindest Natrium enthält,
ein Rückflächenelement (2) aus einem transparenten Kunststofffilm und
einem Solarzellenelement (3, 5), das mit einem Dichtharz zwischen dem Vorderflächenseiten-Lichtübertragungselement (1) und dem Rückflächenelement (2) abgedichtet ist, wobei das Solarzellenelement einen Halbleiterübergang aufweist, der auf der Seite der Solarzelle angeordnet ist, die von dem Vorderflächenseiten-Lichtübertragungselement weg-weisend ist.

2. Solarzellenmodul nach Anspruch 1, wobei das Rückflächenelement ein transparenter Harzfilm ist.

3. Solarzellenmodul nach Anspruch 1, wobei das Solarzellenelement (3, 5) ein einkristallines Siliciumsolarzellenelement vom Wärmediffusionstyp ist.

4. Solarzellenmodul nach Anspruch 1, wobei das Solarzellenelement (3, 5) eine amorphe Halbleiterschicht in zumindest einem Teil des Solarzellenelements aufweist.

5. Solarzellenmodul nach Anspruch 1, wobei das Solarzellenelement (5) einen Hetero-Übergang (52) zwischen einem kristallinen Halbleiter (51) und einem amorphen Halbleiter (53) aufweist.

## Revendications

1. Module de cellule photovoltaïque comprenant :
un élément transmetteur de lumière côté surface avant (1) en verre et contenant au moins du sodium,
un élément de surface arrière (2) réalisé en un film transparent en matière plastique, et
un élément de cellule photovoltaïque (3, 5) scellé avec une résine de scellement entre l'élément transmetteur de lumière côté surface avant (1) et l'élément de surface arrière (2),
dans lequel l'élément de cellule photovoltaïque présente une jonction semi-conductrice positionnée sur la face de la cellule photovoltaïque opposée à l'élément transmetteur de lumière côté surface avant.

2. Module de cellule photovoltaïque selon la revendication 1,
dans lequel l'élément de surface arrière est un film transparent en résine.

3. Module de cellule photovoltaïque selon la revendication 1,
dans lequel l'élément de cellule photovoltaïque (3, 5) est un élément de cellule photovoltaïque en silicium monocristallin du type diffusant la chaleur.

4. Module de cellule photovoltaïque selon la revendication 1,
dans lequel l'élément de cellule photovoltaïque (3, 5) comporte une couche semi-conductrice amorphe sur au moins une partie de l'élément de cellule photovoltaïque.

5. Module de cellule photovoltaïque selon la revendication 1,
dans lequel l'élément de cellule photovoltaïque (5) comporte une hétérojonction (52) entre un semi-conducteur cristallin (51) et un semi-conducteur amorphe (53).
